# EUROPEAN PATENT SPECIFICATION

(11) **EP 3 427 071 B1**
(45) Date of publication and mention of the grant of the patent: **08.04.2020**
(21) Application number: 17709304.4
(22) Date of filing: 24.02.2017
(51) Int. Cl.: H01L 23/473, G05D 23/19, G05D 23/22, F28F 3/12

(54) **SYSTEM AND METHOD FOR TEMPERATURE FORCING WITH CONDUCTIVE THERMAL PROBES**
SYSTEM UND VERFAHREN ZUR TEMPERATUREINPRÄGUNG ANHAND VON LEITFÄHIGEN THERMISCHEN SONDEN
SYSTÈME ET PROCÉDÉ DE FORCEMENT DE TEMPERATURES À SONDES THERMIQUES CONDUCTIVES

(30) Priority: 08.03.2016 US 201662305263 P; 21.02.2017 US 201715437861
(43) Date of publication of application: 16.01.2019
(73) Proprietor: Temptronic Corporation, Mansfield, MA 02048 (US)
(72) Inventor: ELSDOERFER, Norbert, Mansfield, Massachusetts 02048 (US)
(74) Representative: Miller, John Owen
(86) International application number: PCT/US2017/019275
(87) International publication number: WO 2017/155707

(56) References cited:
- WO-A1-01/06273
- WO-A2-02/05051
- US-A1- 2015 109 009

## Description

### BACKGROUND

### 1. Technical Field

The present invention generally relates to temperature forcing systems, which provide a stream of fluid at a precisely-controlled temperature and flow rate, and are commonly used in temperature testing of electronic devices, modules and systems, and, in particular, to a temperature forcing system which uses heat flow by conduction instead of convection to apply temperature control of a device under test (DUT) with increased efficiency and spatial precision.

### 2. Discussion of Related Art

A temperature forcing system is a device which produces a stream of flowing fluid, such as air, nitrogen or other inert gas, at a precisely-controlled temperature and flow rate. Such systems are commonly used in temperature testing of electronic devices, modules and systems. In this application, a stream of temperature-controlled fluid is directed onto the device under test (DUT) to affect the temperature of the DUT. The DUT is then run through a series of performance tests to determine whether the performance of the DUT at various temperatures is acceptable.

These temperature stream testing systems use convection heat transfer to control temperature of the DUT. Oftentimes, it can be desirable to direct the temperature altering mechanism, i.e., stream, precisely, such that only the portion of the DUT actually being tested is affected by the temperature stream. This can result in a reduction in lost temperature control fluid, and, therefore, a more efficient testing system and process.

### SUMMARY

According to one aspect, a temperature-controlled fluid forcing system is provided. The system includes a temperature control system for cooling and/or heating a fluid and generating a stream of flowing temperature-controlled fluid. A conduit directs the stream of flowing temperature-controlled fluid through a first outlet. A heat exchanger receives the stream of temperature-controlled fluid from the first outlet. The heat exchanger comprises: (i) a thermally conductive housing having an interior and an exterior, (ii) an inlet at which the stream of temperature-controlled fluid is received, such that the stream of temperature-controlled fluid is directed into the interior of the housing, (iii) a plurality of walls within the interior of the housing, the plurality of walls defining a shaped flow space within the interior of the housing, the inlet being in communication with the shaped flow space such that the stream of temperature-controlled fluid flows through the shaped flow space and is in thermal communication with the housing, and (iv) a second outlet in communication with the shaped flow space such that the stream of temperature-controlled fluid is exhausted from the interior of the housing through the second outlet after flowing through the shaped flow space;. A thermally conductive probe is disposed in thermal communication with the exterior of the housing of the heat exchanger, the thermally conductive probe comprising a thermally conductive protrusion in thermal communication with the exterior of the housing of the heat exchanger, such that, when the thermally conductive probe makes contact with a device under test (DUT), heat is conducted to or from DUT.

In some exemplary embodiments, when the thermally conductive probe makes contact with the device under test (DUT), temperature of the DUT is controllable.

In some exemplary embodiments, the system further comprises a temperature sensing device for sensing temperature of the thermally conductive probe, the temperature of the thermally conductive probe being used to control temperature of the DUT.

In some exemplary embodiments, the system further comprises a temperature sensing device for sensing temperature of the DUT, such that temperature of the DUT is controllable.

In some exemplary embodiments, the shaped flow space in the interior of the housing of the heat exchanger comprises a serpentine shape.

In some exemplary embodiments, the housing of the heat exchanger comprises a thermally conductive material. The thermally conductive material can comprise metal. The thermally conductive material can comprise aluminum. The thermally conductive material can comprise copper.

In some exemplary embodiments, the thermally conductive probe comprises a thermally conductive material. The thermally conductive material can comprise metal. The thermally conductive material can comprise aluminum. The thermally conductive material can comprise copper.

### BRIEF DESCRIPTION OF THE DRAWINGS

The foregoing and other objects, features and advantages will be apparent from the following, more particular description of the embodiments, as illustrated in the accompanying figures, wherein like reference characters generally refer to identical or structurally and/or functionally similar parts throughout the different views. The figures are not necessarily to scale, emphasis instead being placed upon illustrating the principles of the embodiments.
Fig. 1 includes a schematic perspective view of a temperature-controlled fluid processing system, for example, a temperature forcing system, e.g., air forcing system, to which the present disclosure is applicable.
Fig. 2 includes a schematic perspective view of another embodiment of a temperature-controlled fluid processing system, for example, a temperature forcing system, e.g., an air forcing system, to which the present disclosure is applicable.
Fig. 3 includes a detailed schematic diagram of a portion of temperature forcing system of Fig. 1, according to another exemplary embodiment.
Fig. 4 includes a schematic diagram of a temperature forcing system, using a conductive temperature probe for controlling temperature of a DUT, according to exemplary embodiments.
Fig. 5 includes a schematic diagram of another temperature forcing system, using a conductive temperature probe for controlling temperature of a DUT, according to exemplary embodiments.
Fig. 6 includes a schematic perspective view of a heat exchanger used in a temperature forcing system, according to some exemplary embodiments.
Fig. 7 includes a schematic cross-sectional view of the heat exchanger of Fig. 6, taken along line 7-7 of Fig. 6, according to exemplary embodiments.
Fig. 8 includes a schematic cross-sectional view of the heat exchanger of Fig. 6, taken along line 8-8 of Fig. 7, according to exemplary embodiments.
Fig. 9A includes a schematic perspective view of a contact probe, according to exemplary embodiments.
Fig. 9B includes a bottom view of the contact probe of Fig. 9A, illustrating the configuration of a contact protrusion portion of the contact probe, according to some exemplary embodiments.
Fig. 10A includes a schematic perspective view of another contact probe, according to exemplary embodiments.
Fig. 10B includes a bottom view of the contact probe of Fig. 10A, illustrating the configuration of a contact protrusion portion of the contact probe, according to some exemplary embodiments.
Fig. 11A includes a schematic perspective view of another contact probe, according to exemplary embodiments.
Fig. 11B includes a bottom view of the contact probe of Fig. 11A, illustrating the configuration of a contact protrusion portion of the contact probe, according to some exemplary embodiments.

### DETAILED DESCRIPTION

In the description that follows, features that are described and/or illustrated with respect to one embodiment may be used in the same way or in a similar way in one or more other embodiments and/or in combination with or instead of the features of the other embodiments.

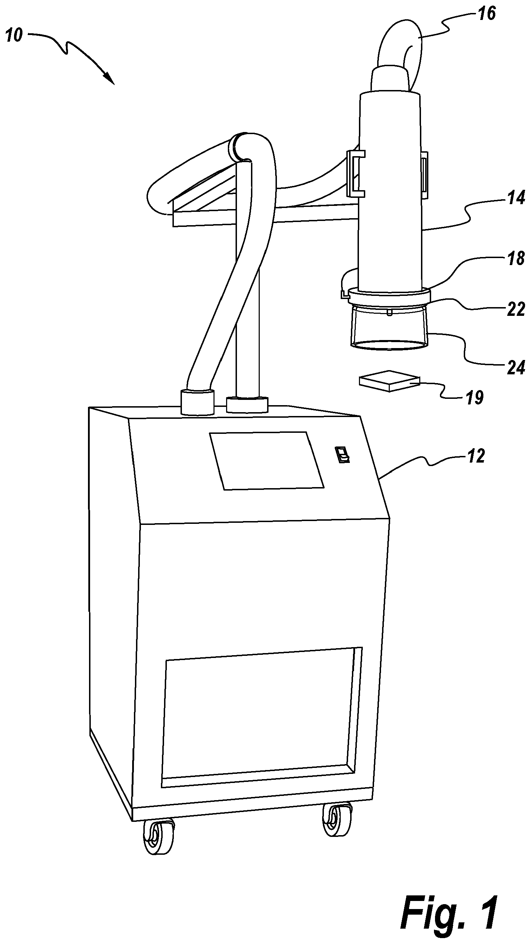

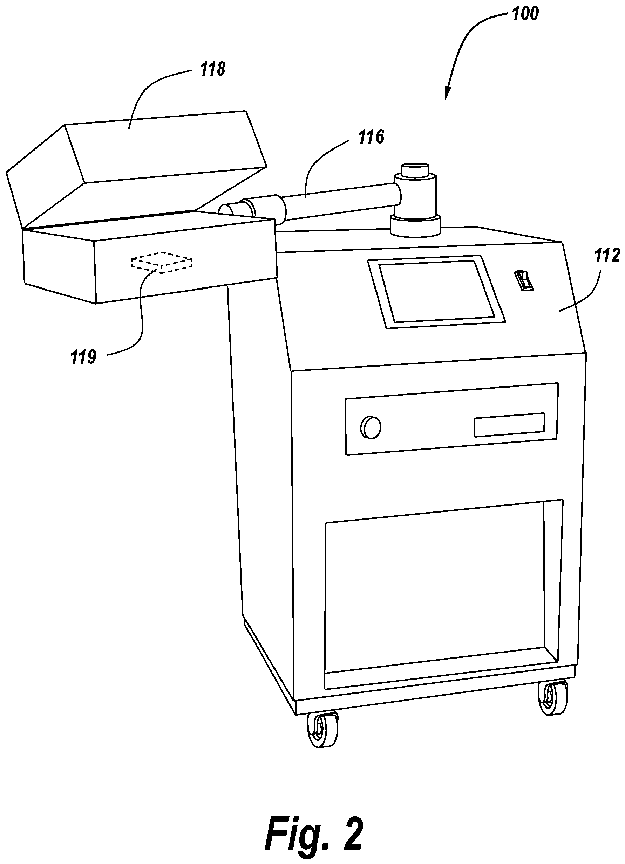

Fig. 1 includes a schematic perspective view of a temperature-controlled fluid processing system, for example, a temperature forcing system, e.g., air forcing system 10, to which the present disclosure is applicable. Fig. 2 includes a schematic perspective view of another embodiment of a temperature-controlled fluid processing system, for example, a temperature forcing system, e.g., air forcing system 100, to which the present disclosure is applicable. Temperature forcing systems 10, 100 to which the present disclosure is directed can be used to produce a fluid such as air, nitrogen, or other inert gas with a precisely controlled temperature and flow rate, and can direct a stream of that fluid into a particular region, such as, for example, onto a device under test (DUT) 19, 119, to control the temperature of the DUT 19, 119. DUT 19, 119 can be an integrated circuit (IC), which can be contained within its IC package. Alternatively, DUT 19, 119 can be a semiconductor wafer with multiple IC dies integrated therein, or it can be a printed circuit board (PCB) with multiple ICs installed thereon. According to some exemplary embodiments, the temperature-controlled forcing system 10, 100 may comprise a THFRMOSTREAM® Air Forcing System, as manufactured and sold by inTEST Thermal Solutions Corporation of Mansfield, Massachusetts, or other similar system.

Temperature forcing systems 10, 100 may include a chiller/controller unit 12, 112, which includes a refrigeration system for generating a stream of dry, cold gas, e.g., air, nitrogen or other fluid. The chilled fluid may be directed into a fluid conveyor, such as a tube and hose system 16, 116 which in system 10 directs the air into a head unit 14 and in system 100 directs the air into an insulated "clamshell" box appliance 118, in which DUT 119 is located, such that temperature of DUT 119 can be controlled. Head unit 14 may include a heater for heating the chilled fluid, such that temperature of the fluid can be precisely controlled. The temperature-controlled fluid may exit head 14 through an outlet 18. In some exemplary embodiments, a "T-Cap" thermal cap accessory 22 having a shroud 24 is commonly attached at outlet 18. Shroud 24 can be used to at least partially enclose or cover DUT 19 to provide a contained temperature-controlled environment in which temperature of DUT 19 is controlled. In system 100 of Fig. 2, clamshell appliance 118 provides a contained temperature-controlled environment in which temperature of DUT 19 is controlled.

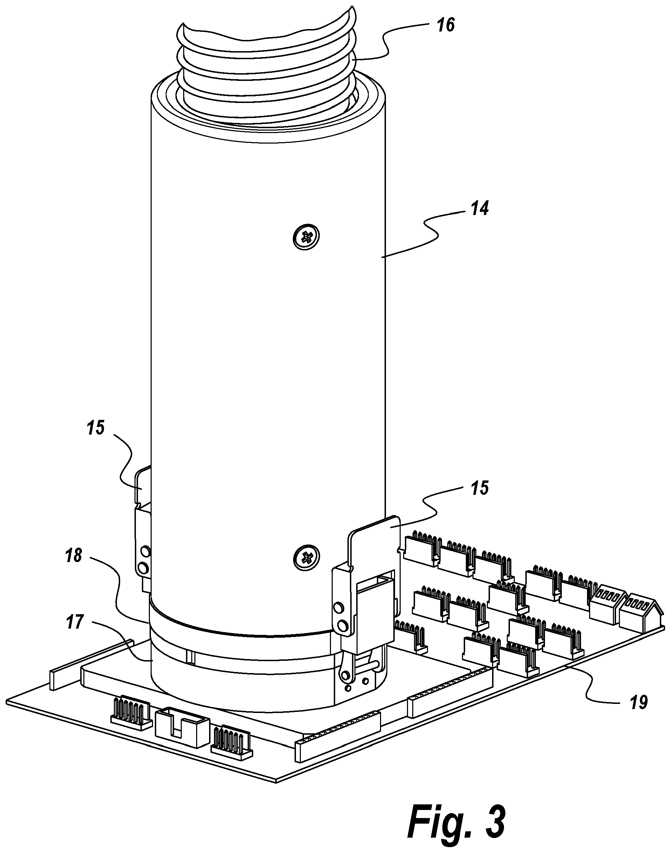

Fig. 3 includes a detailed schematic diagram of a portion of temperature forcing system 10 of Fig. 1, according to another exemplary embodiment. In this embodiment, head unit 14 is connected by claims 15 at outlet 18 to a ring 17, which mounts over and at least partially encloses DUT 19. In this exemplary illustration, DUT 19 is illustrated as a PCB with multiple electronic devices mounted thereon.

Thus, according to temperature forcing systems 10, 100 illustrated in Figs. 1-3, as described above, temperature control is achieved by convection via the flow of the temperature-controlled fluid onto or in close proximity to DUT 19, 119. According to exemplary embodiments, temperature forcing systems 10, 100 can be modified such that heat transfer by conduction is used to force DUTs 19, 119 to a desired test temperature. To achieve this conversion from heat transfer by convection to heat transfer by conduction, according to exemplary embodiments, the output fluid flow from temperature forcing systems 10, 100 is forced into a high-efficiency heat exchanger, which can be positioned in contact with DUT 19, 119. The heat exchanger is maintained in contact with DUT 19, 119 such that the heat transfer is accomplished using a thermal conduction path. One benefit of conductive temperature control of DUT 19, 119 over convective temperature control is that, with the conductive temperature control of the present disclosure, only the device to be tested, i.e., DUT 19, 119, is affected thermally. Other elements, such as, for example, adjacent components and/or the load board itself, can remain thermally isolated while temperature of DUT 19, 119 is affected. This results in substantially reduced loss or waste of temperature control fluid, which in turn produces a more efficient test system and process.

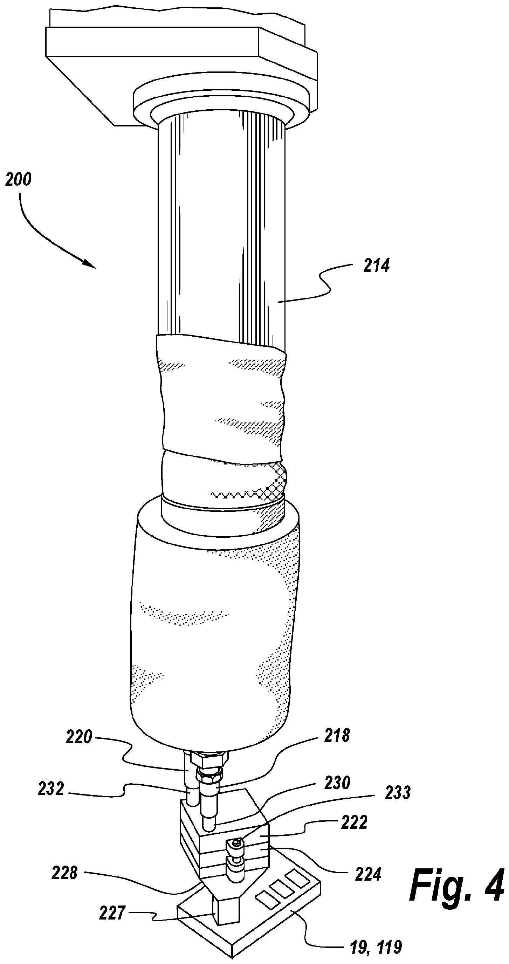

Fig. 4 includes a schematic diagram of a temperature forcing system 200, using a conductive temperature probe for controlling temperature of a DUT, according to exemplary embodiments. Referring to Fig. 4, a portion of system 200 is illustrated to facilitate detailed description. The remainder of system 200 not shown in the figure is the same as that portion of system 10 illustrated in Fig. 1. System 200 includes head unit 214, analogous to head unit 14 of system 10. An outlet pipe structure 218 is coupled to the output of head unit 214 to capture and carry the temperature-controlled fluid output by system 200 for temperature control. Outlet pipe structure 218 transports the temperature-controlled fluid into an inlet 230 of high-efficiency heat exchanger 222, which circulates the fluid internally and outputs the fluid at outlet 232, which is connected to exhaust pipe 220. The temperature-controlled fluid circulating in the interior of heat exchanger 222 transfers heat to/from the thermally conductive body of heat exchanger 222, which contacts an optional thermally conductive thermocouple mounting plate 224. Thermocouple mounting plate 224 can be used as a means for mounting and connecting a thermocouple in proximity to or in contact with heat exchanger 222 to monitor its temperature, if desired. This can provide an optional temperature parameter input, which can be used, if desired, in the temperature control function of system 200.

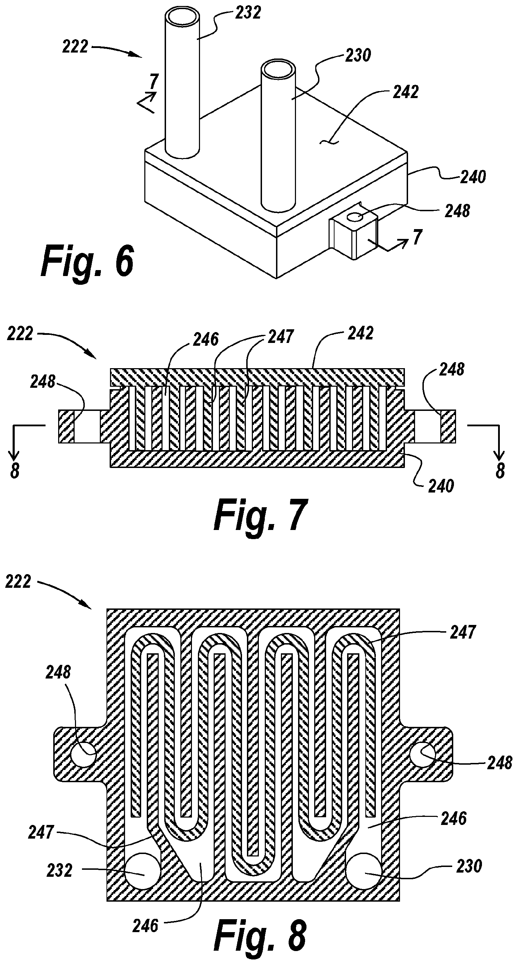

When present, thermally conductive thermocouple mounting plate 224 is thermally connected to a thermally conductive DUT contact probe 228, which is mounted on the bottom surface of thermally conductive thermocouple mounting plate 224. If thermally conductive thermocouple mounting plate 224 is not present, then thermally conductive DUT contact probe 228 is mounted to the bottom surface of heat exchanger 222. In either configuration, heat transfer to/from DUT 19, 119 is effected conductively by contact of a contact protrusion portion 227 of thermally conductive DUT contact probe 228 with DUT 19, 119. It is noted that, in some exemplary embodiments, heat exchanger 222, thermocouple mounting plate 224, and DUT contact probe 228 can be held together by one or more pins 233 through mounting holes 248 in mounting bosses 235 (see Figs. 6-8). Other means of attachment can be used, such as screws, nuts and bolts, etc.

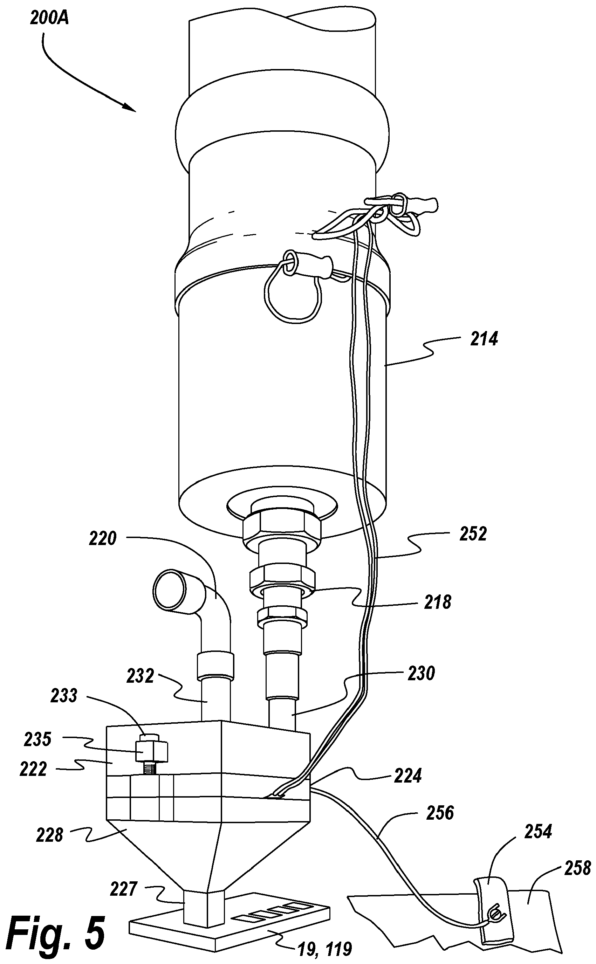

Fig. 5 includes a schematic diagram of a temperature forcing system 200A, using a conductive temperature probe for controlling temperature of a DUT, according to exemplary embodiments. Referring to Fig. 5, a portion of system 200A is illustrated to facilitate detailed description. The remainder of system 200A not shown in the figure is the same as that portion of system 10 illustrated in Fig. 1. System 200A of Fig. 5 is similar to system 200 of Fig. 4, except that Fig. 5 illustrates system 200A making use of one or more thermocouples to monitor one or more respective temperature parameters which optionally can be used in the temperature control implemented by system 200A. Referring to Fig. 5, system 200A includes head unit 214, analogous to head unit 14 of system 10. Outlet pipe structure 218 is coupled to the output of head unit 214 to capture and carry the temperature-controlled fluid output by system 200 for temperature control. Outlet pipe structure 218 transports the temperature-controlled fluid into an inlet 230 of high-efficiency heat exchanger 222, which circulates the fluid internally and outputs the fluid at outlet 232, which is connected to exhaust pipe 220. The temperature-controlled fluid circulating in the interior of heat exchanger 222 transfers heat to/from the thermally conductive body of heat exchanger 222, which contacts an optional thermally conductive thermocouple mounting plate 224. Thermocouple mounting plate 224 can be used as a means for mounting and connecting a thermocouple (not shown) in proximity to or in contact with heat exchanger 222 to monitor its temperature, if desired. An optional second thermocouple 254 can be mounted to and monitor temperature of a portion 258 of system 200A in proximity to DUT 19, 119. The thermocouples are wired via wires 256 and 252, via head 214, to system controller in chiller/controller unit 12, 112. This can provide one or more optional temperature parameter inputs, which can be used, if desired, in the temperature control function of system 200A.

When present, thermally conductive thermocouple mounting plate 224 is thermally connected to a thermally conductive DUT contact probe 228, which is mounted on the bottom surface of thermally conductive thermocouple mounting plate 224. If thermally conductive thermocouple mounting plate 224 is not present, then thermally conductive DUT contact probe 228 is mounted to the bottom surface of heat exchanger 222. In either configuration, heat transfer to/from DUT 19, 119 is effected conductively by contact of a contact protrusion portion 227 of thermally conductive DUT contact probe 228 with DUT 19, 119. It is noted that, in some exemplary embodiments, heat exchanger 222, thermocouple mounting plate 224, and DUT contact probe 228 can be held together by one or more pins 233 through mounting holes 248 in mounting bosses 235 (see Figs. 6-8). Other means of attachment can be used, such as screws, nuts and bolts, etc.

Fig. 6 includes a schematic perspective view of heat exchanger 222, according to some exemplary embodiments. Fig. 7 includes a schematic cross-sectional view of heat exchanger 222, taken along line 7-7 of Fig. 6, according to some exemplary embodiments. Fig. 8 includes a schematic cross-sectional view of heat exchanger 222, taken along line 8-8 of Fig. 7, according to some exemplary embodiments. Referring to Figs. 6-8, heat exchanger 222 includes a thermally conductive housing portion 240 fixedly attached to a thermally conductive cover portion 242. Housing portion 240 and cover portion 242 can be made of similar or like thermally conductive materials such as metals, which can be, for example, aluminum, copper, or other thermally conductive material, and can be sealed together by some thermally conductive means, such as welding, brazing, or other process. As noted above, temperature-controlled fluid from head unit 214 of system 200, 200A enters heat exchanger 222 through inlet 230 and circulates through the interior of heat exchanger 222 via a serpentine pattern of void space 246 defined and contained by interior wall structure 247. The fluid then exits the interior of heat exchanger 222 via outlet 232.

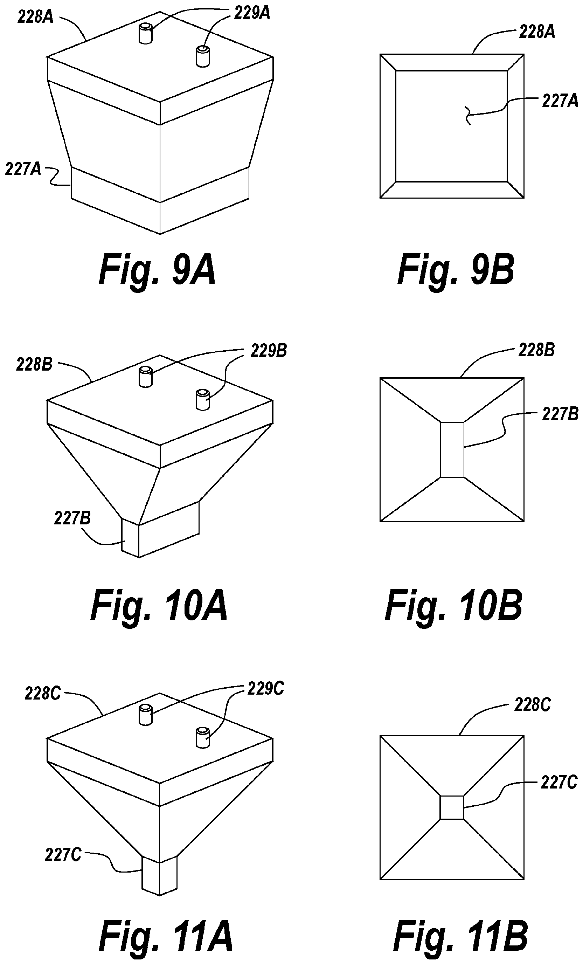

Contact probe 228 can have a size and shape of multiple possible sizes and shapes, depending on the particular needs of the particular application. Also, contact protrusion portion 227 of each contact probe 228 can be sized depending on the application, as well as the size constraints of the DUT 19, 119, or region of DUT 19, 119 at which temperature effect is to be applied. Fig. 9A includes a schematic perspective view of a contact probe 228A, according to exemplary embodiments. Fig. 9B includes a bottom view of contact probe 228A of Fig. 9A, illustrating the configuration of contact protrusion portion 227A of contact probe 228A, according to some exemplary embodiments. Fig. 10A includes a schematic perspective view of a contact probe 228B, according to exemplary embodiments. Fig. 10B includes a bottom view of contact probe 228B of Fig. 10A, illustrating the configuration of contact protrusion portion 227B of contact probe 228B, according to some exemplary embodiments. Fig. 11A includes a schematic perspective view of a contact probe 228C, according to exemplary embodiments. Fig. 11B includes a bottom view of contact probe 228C of Fig. 11A, illustrating the configuration of contact protrusion portion 227C of contact probe 228C, according to some exemplary embodiments. It will be understood that Figs. 9A-11B are not exhaustive of all of the possible configurations of contact probes 228 and associated contact protrusion portions 227. Rather, they illustrate that the configurations provide a wide range of variations depending on the particular application. Any number of configurations is possible.

Referring to Figs. 9A, 10A, 11A, contact probes 228A, 228B, 228C include attachment/location pins 229A, 229B, 229C, respectively. These pins mate with holes on the undersides of heat exchanger 222 or thermocouple mounting plate 224 to locate contact probes 228A, 228B, 228C properly and/or to fixedly mount contact probes 228A, 228B, 228C in thermally conductive contact with heat exchanger 222 or thermocouple mounting plate 224. Contact probe 228 and contact protrusion portions 227 can be made of similar or like thermally conductive materials such as metals, which can be, for example, aluminum, copper, or other thermally conductive material.

## Claims

1. A temperature-controlled fluid forcing system, comprising:
a temperature control system for cooling and/or heating a fluid and generating a stream of flowing temperature-controlled fluid;
a conduit for directing the stream of flowing temperature-controlled fluid through a first outlet (218),
a heat exchanger for receiving the stream of temperature-controlled fluid from the first outlet, the heat exchanger comprising:
a thermally conductive housing having an interior and an exterior,
an inlet (230) at which the stream of temperature-controlled fluid is received, such that the stream of temperature-controlled fluid is directed into the interior of the housing (240), a plurality of walls (247) within the interior of the housing, the plurality of walls defining a shaped flow space within the interior of the housing, the inlet being in communication with the shaped flow space such that the stream of temperature-controlled fluid flows through the shaped flow space and is in thermal communication with the housing, and a second outlet (232) in communication with the shaped flow space such that the stream of temperature-controlled fluid is exhausted from the interior of the housing through the second outlet after flowing through the shaped flow space; and
a thermally conductive probe (228) in thermal communication with the exterior of the housing of the heat exchanger, the thermally conductive probe comprising a thermally conductive protrusion 227 in thermal communication with the exterior of the housing of the heat exchanger, such that, when the thermally conductive probe makes contact with a device under test (DUT), heat is conducted to or from DUT.

2. The system of claim 1, wherein, when the thermally conductive probe makes contact with the device under test (DUT), temperature of the DUT is controllable.

3. The system of claim 1, further comprising a temperature sensing device for sensing temperature of the thermally conductive probe, the temperature of the thermally conductive probe being used to control temperature of the DUT.

4. The system of claim 1, further comprising a temperature sensing device for sensing temperature of the DUT, such that temperature of the DUT is controllable.

5. The system of claim 1, wherein the shaped flow space in the interior of the housing of the heat exchanger comprises a serpentine shape.

6. The system of claim 1, wherein the housing of the heat exchanger comprises a thermally conductive material.

7. The system of claim 6, wherein the thermally conductive material comprises metal.

8. The system of claim 6, wherein the thermally conductive material comprises aluminum.

9. The system of claim 6, wherein the thermally conductive material comprises copper.

10. The system of claim 1, wherein the thermally conductive probe comprises a thermally conductive material.

11. The system of claim 10, wherein the thermally conductive material comprises metal.

12. The system of claim 10, wherein the thermally conductive material comprises aluminum.

13. The system of claim 10, wherein the thermally conductive material comprises copper.

## Patentansprüche

1. Temperaturgesteuertes Fluid-Zwangssystem, umfassend:
ein Temperatursteuerungssystem zum Kühlen und/oder Erwärmen eines Fluids und zum Erzeugen eines Stroms eines strömenden, temperaturgesteuerten Fluids;
eine Leitung zum Leiten des Stroms eines strömenden, temperaturgesteuerten Fluids durch einen ersten Auslass (218), einen Wärmetauscher zur Aufnahme des Stroms des temperaturgesteuerten Fluids aus dem ersten Auslass, wobei der Wärmetauscher Folgendes umfasst:
ein wärmeleitendes Gehäuse mit einem Innenraum und einer Außenseite, einem Einlass (230), an dem der Strom des temperaturgesteuerten Fluids empfangen wird, so dass der Strom des temperaturgesteuerten Fluids in das Innere des Gehäuses (240) geleitet wird, mehrere Wände (247) im Inneren des Gehäuses, wobei die mehreren Wände einen geformten Strömungsraum im Inneren des Gehäuses definieren, wobei der Einlass mit dem geformten Strömungsraum in Verbindung steht, so dass der Strom des temperaturgesteuerten Fluids durch den geformten Strömungsraum strömt und in thermischer Verbindung mit dem Gehäuse steht, und einen zweiten Auslass (232), der mit dem geformten Strömungsraum in Verbindung steht, so dass der Strom des temperaturgesteuerten Fluids nach dem Durchströmen durch den geformten Strömungsraum über den zweiten Auslass aus dem Inneren des Gehäuses ausgestoßen wird; und
eine wärmeleitende Sonde (228) in thermischer Verbindung mit der Außenseite des Gehäuses des Wärmetauschers, wobei die wärmeleitende Sonde einen wärmeleitenden Überstand (227) in thermischer Verbindung mit der Außenseite des Gehäuses des Wärmetauschers aufweist, so dass, wenn die wärmeleitende Sonde mit einem Prüfling (DUT) in Kontakt kommt, Wärme zum oder vom DUT geleitet wird.

2. System nach Anspruch 1, wobei die Temperatur des Prüflings steuerbar ist, wenn die wärmeleitende Sonde mit dem Prüfling (DUT) in Kontakt kommt.

3. System nach Anspruch 1, ferner umfassend eine Temperaturerfassungsvorrichtung zum Erfassen der Temperatur der wärmeleitenden Sonde, wobei die Temperatur der wärmeleitenden Sonde zur Steuerung der Temperatur des DUT verwendet wird.

4. System nach Anspruch 1, ferner umfassend eine Temperaturerfassungsvorrichtung zum Erfassen der Temperatur des Prüflings, so dass die Temperatur des Prüflings steuerbar ist.

5. System nach Anspruch 1, wobei der geformte Strömungsraum im Inneren des Gehäuses des Wärmetauschers eine Schlangenform aufweist.

6. System nach Anspruch 1, wobei das Wärmetauschergehäuse ein wärmeleitendes Material umfasst.

7. System nach Anspruch 6, wobei das wärmeleitende Material Metall umfasst.

8. System nach Anspruch 6, wobei das wärmeleitende Material Aluminium umfasst.

9. System nach Anspruch 6, wobei das wärmeleitende Material Kupfer umfasst.

10. System nach Anspruch 1, wobei die wärmeleitende Sonde ein wärmeleitendes Material umfasst.

11. System nach Anspruch 10, wobei das wärmeleitende Material Metall umfasst.

12. System nach Anspruch 10, wobei das wärmeleitende Material Aluminium umfasst.

13. System nach Anspruch 10, wobei das wärmeleitende Material Kupfer umfasst.

## Revendications

1. Système de forçage de fluide à température régulée, comprenant :
un système de régulation de température permettant de refroidir et/ou de chauffer un fluide et de générer un flux de fluide à température régulée ;
un conduit permettant de diriger le flux de fluide à température régulée s'écoulant à travers une première sortie (218), un échangeur de chaleur destiné à recevoir le flux de fluide à température régulée depuis la première sortie, l'échangeur de chaleur comprenant :
un boîtier thermoconducteur comportant un intérieur et un extérieur, une entrée (230) à laquelle le flux de fluide à température régulée est reçu, de sorte que le flux de fluide à température régulée soit dirigé vers l'intérieur du boîtier (240), un pluralité de parois (247) à l'intérieur du boîtier, la pluralité de parois définissant un espace d'écoulement façonné à l'intérieur du boîtier, l'entrée étant en communication avec l'espace d'écoulement formé de telle manière que le flux de fluide à température régulée s'écoule à travers l'espace d'écoulement façonné et est en communication thermique avec le boîtier, et une seconde sortie (232) en communication avec l'espace d'écoulement formé de telle manière que le flux de fluide à température régulée soit évacué de l'intérieur du boîtier par la seconde sortie après s'être écoulé à travers l'espace d'écoulement formé ; et
une sonde thermoconductrice (228) en communication thermique avec l'extérieur du boîtier de l'échangeur de chaleur, la sonde thermoconductrice comprenant une saillie thermoconductrice 227 en communication thermique avec l'extérieur du boîtier de l'échangeur de chaleur, de sorte que, lorsque le la sonde thermoconductrice entre en contact avec un dispositif sous test (DUT), la chaleur est dirigée vers le DUT ou depuis celui-ci.

2. Système selon la revendication 1, dans lequel, lorsque la sonde thermoconductrice entre en contact avec le dispositif sous test (DUT), la température du DUT est réglable.

3. Système selon la revendication 1, comprenant en outre un dispositif de détection de température pour détecter la température de la sonde thermoconductrice, la température de la sonde thermoconductrice étant utilisée pour réguler la température du DUT.

4. Système selon la revendication 1, comprenant en outre un dispositif de détection de température pour détecter la température du DUT, de sorte que la température du DUT soit réglable.

5. Système selon la revendication 1, dans lequel l'espace d'écoulement formé à l'intérieur du logement de l'échangeur de chaleur comprend une forme serpentine.

6. Système selon la revendication 1, dans lequel le boîtier de l'échangeur de chaleur comprend un matériau thermoconducteur.

7. Système selon la revendication 6, dans lequel le matériau thermoconducteur comprend du métal.

8. Système selon la revendication 6, dans lequel le matériau thermoconducteur comprend de l'aluminium.

9. Système selon la revendication 6, dans lequel le matériau thermoconducteur comprend du cuivre.

10. Système selon la revendication 1, dans lequel la sonde thermoconductrice comprend un matériau thermoconducteur.

11. Système selon la revendication 10, dans lequel le matériau thermoconducteur comprend du métal.

12. Système selon la revendication 10, dans lequel le matériau thermoconducteur comprend de l'aluminium.

13. Système selon la revendication 10, dans lequel le matériau thermoconducteur comprend du cuivre.
